Europäisches Patentamt

European Patent Office

Office européen des brevets

(11) Veröffentlichungsnummer: **0 372 666 A1**

## (12) EUROPÄISCHE PATENTANMELDUNG

(21) Anmeldenummer: 89250089.3

(22) Anmeldetag: 16.11.89

(51) Int. Cl.⁵: **G01R 31/28**

(30) Priorität: 23.11.88 DE 3839539

(43) Veröffentlichungstag der Anmeldung:
13.06.90 Patentblatt 90/24

(84) Benannte Vertragsstaaten:
**CH FR GB LI NL**

(71) Anmelder: **Thom, Werner, Dipl.-Ing.
Iserlohner Strasse 14
D-2800 Bremen 1(DE)**

(72) Erfinder: **Thom, Werner, Dipl.-Ing.
Iserlohner Strasse 14
D-2800 Bremen 1(DE)**

(74) Vertreter: **Eisenführ, Speiser & Strasse
Martinistrasse 24
D-2800 Bremen 1(DE)**

(54) **Multikompatible Halteeinrichtung für zu prüfende Leiterplatten bzw. Flachbaugruppen, und für Kontaktstift-Trägerplatten und Niederhalteplatten zur Verwendung in Prüfgeräten.**

(57) Gegenstand der Erfindung ist eine multikompatible Halteeinrichtung für zu prüfende Leiterplatten, Flachbaugruppen, elektromechanische Baugruppen und Geräte; und für die hierzu notwendigen Kontaktstift-Trägerplatten und Niederhalteplatten. Um eine Verwendung von auf einen bestimmten Leiterplatten-bzw. Flachbaugruppentyp zugeschnittenen Niederhalte- bzw. Prüflingsaufnahme- oder Kontaktstift-Trägerplatten auf beliebigen Prüfgeräten zu ermöglichen und damit die notwendigen Investitionen sowie bereitzustellenden Lagerräume zu verringern, wird ein aus Rahmen und nutenförmigen mit dem jeweiligen Prüfgeräte fest verbundenen Aufnahmeelementen bestehendes Baukastensystem vorgeschlagen.

Hierdurch wird eine Durchgängigkeit in der gesamten Fertigung, einschließlich Laboratorien und Wareneingangskontrollen von einem manuellen Prüfgerät bis hin zum großen On-line- oder In-line-Prüfautomaten erzielt.

Fig. 1

## Multikompatible Halteeinrichtung für zu prüfende Leiterplatten bzw. Flachbaugruppen, und für Kontaktstift-Trägerplatten und Niederhalteplatten zur Verwendung in Prüfgeräten

Die Erfindung betrifft eine Halteeinrichtung für zu prüfende Leiterplatten, Flachbaugruppen, elektromechanische Baugruppen und Geräte; und für Kontaktstift-Trägerplatten und Niederhalteplatten zur Verwendung in Prüfgeräten.

Moderne elektronische Geräte, wie beispielsweise Computer, Meß- und Regelgeräte, Geräte der Unterhaltungselektronik etc. sind üblicherweise sowohl in elektrischer wie auch in mechanischer Hinsicht aus mehreren Baugruppen aufgebaut. Eine Baugruppe besteht dabei üblicherweise aus einer Leiterplatte, die entweder ein- oder zweiseitig mit den entsprechenden aktiven und passiven elektrischen Bauelementen, wie beispielsweise Widerständen, Transistoren und IC's bestückt ist. Die gesamte Baugruppe, die häufig auch als SMD-Leiterplatte (surface mounted device) oder als Flachbaugruppe bezeichnet wird, wird i.a. in Form eines Einschubes über eine Steckverbindung, meist in Form einer Messerleiste, elektrisch und mechanisch mit dem restlichen Gerät verbunden. Auf einer Leiterplatte könnten auch elektromechanische Einheiten, wie beispielsweise größere Relais, angeordnet sein, so daß die gesamte Einheit dann als elektromechanische Baugruppe angesprochen wird.

Flachbaugruppen der geschilderten Art werden üblicherweise auf semi- oder vollautomatischen Bestückungs- und Verzinnungsanlagen gefertigt und anschließend in umfangreichen Prüfungsprozeduren auf ihre Funktionssicherheit hin überprüft. Hierzu ist es einerseits möglich, die zu prüfende Flachbaugruppe über die serienmäßig vorgesehene Steckverbindung mit einem elektrischen Prüfgerät zu kontaktieren, andererseits ist es - angesichts der immer komplexer werdenden elektronischen Schaltungen und der damit verbundenen Störanfälligkeit -notwendig, auch sogenannte "In-circuit-Tests" durchzuführen, bei denen beispielsweise integrierte Schaltungen (IC's) in auf der Halbleiterplatte eingelötetem Zustand an bestimmten Punkten kontaktiert werden, woraufhin dann verschiedene Prüf-und Abgleichroutinen durchgeführt werden können.

Zur rationellen Durchführung der Prüfung bzw. des Abgleichs einer Flachbaugruppe in der automatisierten Fertigung werden üblicherweise Prüfgeräte verwendet, in denen die zu prüfende Leiterplatte bzw. Flachbaugruppe in einer definierten Lage gehalten wird, woraufhin dann eine Anordnung von auf einer Platte angeordneten Kontaktstiften gegen die zu prüfende Leiterplatte gedrückt wird, so daß die auf der Leiterplatte bzw. Flachbaugruppe ausgewählten Prüf- bzw. Kontaktstellen kontaktiert werden. Die Kontaktstifte sind dabei über Verbin dungsleitungen mit einem Vielfachstecker verbunden, mit dem die Verbindung zu dem elektrischen Teil der Prüfvorrichtung hergestellt wird. Um die i.a. gegen Biegespannung empfindliche zu prüfende Leiterplatte zu entlasten, werden bei einseitig zu prüfenden Leiterplatten auf der nicht mit Kupfer kaschierten Seite üblicherweise Niederhalteplatten angeordnet, die die von den Kontaktstiften ausgeübten Kräfte aufnehmen. Hierzu sind auf der Niederhalteplatte etwa zapfenförmige Elemente vorgesehen, die auf freie Stellen der Leiterplatte bzw. Flachbaugruppe aufgesetzt werden. Zur Prüfung von beidseitig bestückten Flachbaugruppen sind auch Kombinationen aus Niederhalteplatten und Kontaktstift-Trägerplatten bekannt geworden.

Für die sichere Halterung und Kontaktierung der zu prüfenden Leiterplatte in einem Prüfgerät sind verschiedene Vorrichtungen als Stand der Technik bekannt.

So ist beispielsweise aus der DE-OS 27 50 492 eine Prüfaufnahme für mit elektrischen Bauelementen bestückte, plattenförmige Baugruppen bekannt, bei der die zu prüfende Leiterplatte in eine schwenkbare Führung gesteckt und gegen eine austauschbare Kassette mit Prüfspitzen gedrückt wird.

Aus der DE-AS 24 27 118 ist ein Adapter zum Verbinden der Anschluß- und/oder Prüfpunkte einer auf einem Träger angeordneten elektrischen Baugruppe über Kontaktierungselemente mit den Anschlüssen einer Meßschaltung bekannt, bei dem die zu prüfende Leiterplatte in einem fest mit dem Prüfgerät verbundenen Rahmen gehalten wird und gegen eine Anzahl von Kontaktstiften (Kontaktierungselementen) gedrückt wird, wobei durch Zwischenlegen einer auswechselbaren Rasterplatte mit mit den Prüfstellen korrespondierenden Bohrungen die zum Einsatz kommenden Kontaktstifte ausgewählt werden können.

Auf der letztgenannten Druckschrift aufbauend ist aus der DE-AS 26 28 428 ein Gerät bekannt, bei dem die zu prüfende Leiterplatte ebenfalls in einem U-förmigen Rahmen gehalten wird, und bei dem die Kontaktstifte (Prüfstifte) teilweise beweglich sind.

Aus der DE-OS 32 48 694 ist ein Prüfadapter für flache elektrische Baugruppen bekannt, bei der die zu prüfende Leiterplatte frei, d.h. ohne besondere Fixierungseinrichtung auf gleichmäßig verteilt angeordnete Kontaktstifte (Taststifte) gedrückt wird.

In der DE-OS 34 05 568 ist eine Vorrichtung zur Kontaktierung von Kontakteinheiten zur automatischen Prüfung von Flachbaugruppen beschrieben, bei der die zu prüfende Flachbaugruppe auf eine mit dem Gerät fest verbundene Prüfaufnahme aufgelegt wird wobei durch spezielle Führungsnadeln eine Lagefixierung gewährleistet sein soll.

Schließlich ist aus der DE-PS 35 11 821 ein Adapter zur Aufnahme von beidseitig zu prüfenden Leiterplatten bekannt, bei dem verschiebbare Kontaktstift-Trägerplatten und eine zwischen diesen angeordnete Aufnahmevorrichtung für die zu prüfende Leiterplatte eine getrennt auswechselbare Einheit bilden.

Nahezu allen Prüfgeräten gemeinsam ist, daß für jeden zu prüfenden Leiterplattentyp eine speziell hierauf abgestimmte Kontaktstift-Trägerplatte wie auch häufig eine Niederhalteplatte angefertigt werden und auf Vorrat gehalten werden muß. Es sind verschiedentlich Prüfgeräte vorgeschlagen worden, bei denen dieser Aufwand durch eine universelle Anordnung von Kontaktstiften reduziert werden sollte, die sich jedoch wegen eines zu hohen Bauaufwandes und/oder schlechter Kontaktierungseigenschaften nicht durchsezten konnten:

Die Notwendigkeit, bei Umstellen der Fertigung auf einen anderen Leiterplattentyp die Prüfgeräte mit anderen Kontaktstift-Trägerplatten, ggf. Prüflingsaufnahmeplatten und Niederhalteplatten auszustatten führt zu hohen Rüstzeiten, was insbesondere angesichts des zunehmenden Anteils an sogenannten ASIC's (anwenderspezifische integrierte Schaltungen) und der damit verbundenen relativ kleinen Losgrößen ein gravierender Nachteil ist.

Es ist daher ein Teil der der Erfindung zugrunde liegenden Aufgabe, eine Halteeinrichtung für a) zu prüfende Leiterplatten, Flachbaugruppen, elektromechanische Baugruppen und Geräte, sowie für b) Kontaktstift-Trägerplatten und c) Niederhalteplatten anzugeben, die bei Umstellen der Fertigung auf einen anderen Leiterplattetyp einen schnellen Wechsel der genannten Teile ermöglicht und darüber hinaus möglichst universell zu verwenden ist.

Ein weiterer gravierender Nachteil der bekannten Prüfgeräte bzw. der an diesen verwendeten Halteeinrichtungen für Kontaktstift-Trägerplatten bzw. zu prüfende Leiterplatten etc. ist, daß Kontaktstift-Trägerplatten, sowie ggf. Niederhalteplatten sowie Prüflingsaufnahmaplatten nicht nur auf einen speziellen Leiterplattetyp zugeschnitten sein müssen, sondern darüber hinaus auch nur auf einem bestimmten Prüfgerät verwendet werden können.

Es ist nun aber in Fertigungsbetrieben häufig der Fall, daß verschiedene, aus Fertigungsanlagen und Prüfgeräten bestehende Fertigungsstraßen nebeneinander her existieren, auf die die zu fertigenden Lose an Leiterplatten bzw. Flachbaugruppen nach Kapazitätsanfall o.ä. Gesichtspunkten verteilt werden. Dabei ist es gerade im ATE-Bereich (automatische Testeinrichtungen die Regel, daß Prüf- und Testgeräte wegen der stürmischen Entwicklung der zu prüfenden, immer komplexeren Flachbaugruppen ihrerseits einem schnellen Wandel unterworfen sind, so daß in Fertigungsbetrieben - vor allen Dingen wegen der zu tätigenden Investitionen - häufig ältere und neuere Prüf- bzw. Testgeräte koexistieren.

Gemäß dem bisherigen Stand der Technik war daher die Anzahl der von einem Fertigungsbetrieb zu bevorratenden Kontakstift-Trägerplatten, Niederhalteplatten und ggf. Prüflingsaufnahmeplatten nicht nur von dem Fertigungsprogramm, d.h. der Anzahl der verschiedenen Leiterplattentypen, Flachbaugruppen und Geräte abhänigig, sondern vervielfachte sich auch noch mit der Anzahl der in dem Fertigungsbetrieb verwendeten Prüfgeräte.

Dies war insbesondere für kleinere, insbesondere in der Gründungsphase befindliche Betriebe äußerst nachteilig, da die Anschaffung eines moderneren, ggf. mit einer größeren Anzahl von Prüfroutinen ausgestatteten Prüfgerätes zugleich mit der Notwendigkeit verbunden war, den bisher verwendeten Satz an kontaktstift-Trägerplatten, Niederhalteplatten und ggf. Prüflingsaufnahmeplatten zu erneuern.

Der Erfindung liegt daher weiterhin die Aufgabe zugrunde, eine Halteeinrichtung der genannten Art zu schaffen, die sich auf beliebigen, hierfür vorgesehenen Prüfgeräten verwenden läßt.

Die Lösung der Aufgabe besteht in einer Halteeinrichtung mit den Merkmalen des Ansprüches 1.

Bevorzugte Ausgestaltungen der erfindungsgemäßen Halteeinrichtung sind in den Unteransprüchen beschrieben.

Durch die erfindungsgemäße Ausgestaltung einer Halteeinrichtung - gewissermaßen in Form eines Baukastensystems - wird erstmalig erreicht, daß die zu einem bestimmten Leiterplatten-bzw. Flachbaugruppentyp gehörenden Kontaktstift-Trägerplatten, Niederhalteplatten und ggf. Prüflingsaufnahmeplatten nicht nur auf einem Prüfgerät, sondern auf sämtlichen zur Verwendung mit der Halteeinrichtung hin ausgelegten Prüfgeräten benutzt werden kann. Dabei werden durch die erfindungsgemäß vorgesehene Verwendung von die Platten bzw. Flachbaugruppen aufnehmenden Rahmen mechanisch stabile Einheiten geschaffen, die gut zu handhaben sind und einen schnellen, die Rüstzeiten minimierenden Wechsel zulassen.

Die manuell vorbereiteten, jeweils aus einer Kontaktstift-Trägerplatte, einer Prüflingsaufnahmeplatte oder einer Niederhalteplatte und einem erfindungsgemäßen Rahmen stehenden Einheiten erlauben darüber hinaus die Integration des Prüfvorganges in eine CIM-(Computer integrated manufacturing)Anlage mit In-line-Prüfgeräten.

Verfügt eine Firma nun beispielsweise über eine moderne Fertigungslinie, auf der ein bestimmter Leiterplattentyp normalerweise in großen Stückzahlen vollautomatisch gefertigt und geprüft wird, und ist von diesem Leiterplattetyp außerplanmäßig eine kleine Anzahl zu fertigen, für die die Rüstzeiten der vollautomatischen Fertigungslinie nicht tragbar sind, so ist es wegen der standardisierten Abmessungen der Rahmen ohne weiteres möglich, auf eine andere, ggf. manuell zu bedienenden Fertigungslinie auszuweichen, und so einen Kapazitätsabbau herbeizuführen, ohne daß hierzu etwa neue Kontaktstift-Trägerplatten, Niederhalteplatten etc. anzufertigen wären. Weiterhin können z.B. im Prüflabor technische Erweiterungen anlaufender Serien auf einem Prüfgerät vorbereitet und später in die Fertigungslinie fast ohne Zeitverlust eingeführt werden.

Weiterhin kann erfindungsgemäß vorgesehen werden, die zu prüfenden Leiterplatten bzw. Flachbaugruppen nicht direkt mit dem Rahmen zu verbinden, sondern eine Prüflingsaufnahmeplatte vorzusehen, die in dem Rahmen liegt und in der wiederum die zu prüfende Leiterplatte liegt. Hierdurch ist es möglich, auch Sonderbauformen von Leiterplatten, wie beispielsweise kreisringförmige - beispielsweise zum Aufstecken auf Bildschirmröhren - zu prüfen. Weiterhin ist es bei Verwendung einer Prüflingsaufnahmeplatte möglich, diese zur Aufnahme mehrerer Leiterplatten - insbesondere im Europaformat (100 mm x 160 mm) - vorzusehen, so daß in einem Prüfdurchgang, d.h. mit einmaligem Hoch- bzw. Niederfahren der Kontaktstift-Trägerplatten bzw. Niederhalteplatte gleichzeitig mehrere Prüflinge geprüft werden können und so der Durchsatz an Prüflingen wesentlich erhöht werden kann.

Weiterhin kann erfindungsgemäß vorgesehen sein, zumindest zwei verschiedene Rahmentypen vorzusehen, deren Abmessungen so ausgelegt sind, daß zwei Rahmen des kleineren Rahmentyps in einen größeren Rahmen eingelegt werden können, wodurch eine noch höhere Flexibilität erreicht wird. Hierdurch kann es einem Hersteller beispielsweise ermöglicht werden, zwei verschiedene Geräteserien anzubieten, von denen die eine für die Aufnahme des kleineren Rahmentyps ausgelegt ist - also etwa eine Reihe von kleineren, manuell zu bedienenden Prüfgeräten umfaßt - und die andere für die Aufnahme des größeren Rahmentyps gedacht ist, ersatzweise aber zwei kleinere Rahmen aufnehmen kann. Hierdurch wird eine Durchgängigkeit in der Fertigung von einem manuellen Prüfgerät bishin zu einem großen In-line-Prüfautomaten erzielt.

Grundgedanke der Erfindung ist es jedoch, eine multikompatible - d.h. an verschiedene Prüfgeräte passende - Halteeinrichtung zu schaffen, in dem die zur Aufnahme der Rahmen bei dem jeweiligen Prüfgerät vorgesehenen Aufnahmeelemente in einem bie allen Prüfgeräten gleichen, d.h. also standardisiertem Abstand angeordnet sind.

Die Erfindung wird im folgenden anhand der Zeichnung näher beschrieben. In der Zeichnung zeigen:

Fig. 1 drei übereinander angeordnete, eine Niederhalteplatte, eine einseitig bestückte, zu prüfende Leiterplatte und eine Kontaktstift-Trägerplatte aufnehmende, erfindungsgemäße Rahmen, die in mit dem jeweiligen Prüfgerät fest verbundene Aufnahmeelemente eingeschoben sind, wobei das Prüfgerät selbst nicht darge stellt ist, und

Fig. 2 einen senkrechten Schnitt durch drei erfindungsgemäße Rahmen, mit den dazugehörigen Aufnahmeelementen in einer Anordnung zur Prüfung einer zweiseitig bestücken Leiterplatte.

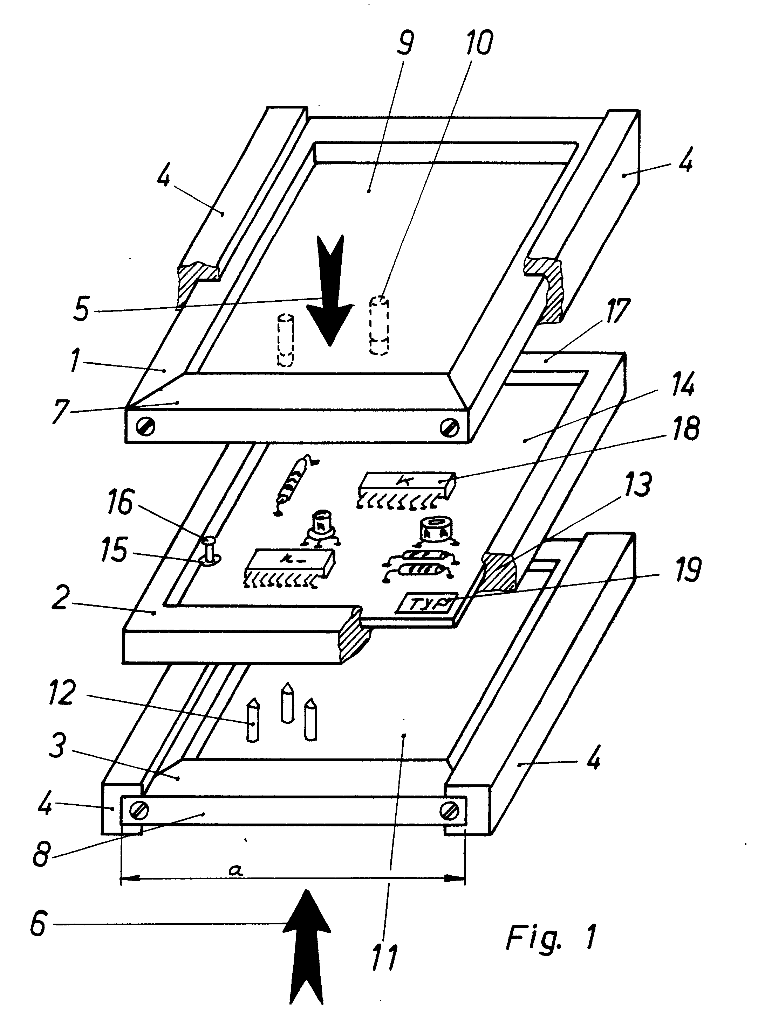

Die in Fig. 1 dargestellte perspektivische Anordnung besteht aus drei erfindungsgemäßen Rahmen 1, 2 und 3, wobei die Rahmen 1 und 3 baugleich sind. Die Rahmen sind in nutenförmige Aufnahmeelemente 4 eingeschoben, die in der Zeichnung teilweise weggebrochen dargestellt bzw. hinsichtlich des mittleren Rahmens 2 weggelassen worden sind, um die Übersichtlichkeit der Darstellung zu fördern.

Der obere Rahmen 1 ist über zwei nutenförmige Aufnahmeelemente 4 mit einem entsprechend beweglichen Teil des Prüfgerätes verbunden, so daß er in Richtung des Pfeiles 5 - beispielsweise hydraulisch oder pneumatisch - abgesenkt werden kann. Entsprechend ist der untere Rahmen 3 über nutenförmige Aufnahmeelemente 4 mit einem Teil des Prüfgerätes verbunden, das in Richtung des Pfeiles 6 - ebenfalls hydraulisch oder pneumatisch - nach oben verfahren werden kann.

Der mittlere Rahmen 2 ist ebenfalls über nutenförmige Aufnahmeelemente, die hier nicht dargestellt sind, mit dem Prüfgerät verbunden.

Der obere Rahmen 1 wie auch der untere Rahmen 3 weist an einer Schmalseite einen schnell lösbaren Querriegel 7 bzw. 8 auf, nach dessen Lösen eine Platte in den an seiner Innenseite eine umlaufende U-förmige Nut aufweisenden Rahmen eingeschoben werden kann. Im vorliegenden Falle ist in den oberen Rahmen 1 eine Niederhalteplatte 9 eingeschoben, die auf ihrer Unterseite zapfenförmige Andrückelemente 10 aufweist. In den unteren Rahmen 3 ist eine Kontaktstift-Trägerplatte 11 eingeschoben, die an ihrer Oberseite Kontaktstifte 12 aufweist.

Der mittlere Rahmen 2 weist eine auf der Innenseite umlaufende L-förmige Nut 13 auf, in die eine zu prüfende Leiterplatte 14 eingelegt werden kann. In der L-förmigen Nut 13 können jeweils mit einer entsprechenden Bohrung 15 in der zu prüfenden Leiterplatte 14 korrespondierende Paßstifte 16 angeordnet sein, mit denen beispielsweise eine seitenverkehrte Lage der zu prüfenden Leiterplatte 14 ausgeschlossen werden kann. Im Bereich der hinteren Schmalseite 17 des Rahmens 2 können steckerförmige Kontaktelemente angeordnet sein, um beispielsweise an der zu prüfenden Leiterplatte vorhandene Messerleisten zu kontaktieren.

Die Anordnung der Kontaktstifte 12 auf der Kontaktstift-Trägerplatte 11 entspricht der Anordnung der zu kontaktierenden Prüfpunkte auf der Unterseite der zu prüfenden Leiterplatte 14. Die Anordnung der zapfenförmigen Andrückelemente 10 auf der Unterseite der Niederhalteplatte 9 korrespondiert mit der auf der Oberseite der Leiterplatte 14 zwischen den Bauelementen 18 verbleibenden freien Stellen.

Nachdem die drei Rahmen mit den entsprechenden Platten bestückt und in das Prüfgerät eingeschoben worden sind, werden die drei Rahmen durch entsprechendes Verfahren der Prüfgerätsteile, mit denen sie über die nutenförmigen Aufnahmeelenemte 4 verbunden sind, in Richtung der Pfeile 5 bzw. 6 aufeinander zu verfahren, so daß die zapfenförmigen Andrückelemente 10 der Niederhalteplatte 9 mit den entsprechenden freien Stellen auf der Oberseite der zu prüfenden Leiterplatte 14 und die Kontaktstifte 12 auf der Kontaktstift-Trägerplatte 11 mit den zu kontaktierenden Prüfpunkten auf der Unterseite der zu prüfenden Leiterplatte 14 in Berührung kommen, woraufhin die eigentliche elektrische Prüfroutine durchgeführt werden kann.

Erfindungsgemäß weisen die nutenförmigen, jeweils paarweise zur Aufnahme eines Rahmens 1, 2 oder 3 vorgesehenen Aufnahmeelemente 4 bei jedem zur Verwendung mit der erfindungsgemäßen Halteeinrichtung vorgesehenen Prüfgerät den gleichen Abstand a auf, so daß die Rahmen mit den entsprechenden, auf einen bestimmten zu prüfenden Leiterplattetyp 19 zugeschnittenen Niederhalteplatten 9 bzw. Kontaktstift-Trägerplatten 11 bei einem Wechsel auf ein anderes Prüfgerät - beispielsweise auf ein moderneres, mit umfassenderen Programmiermöglichkeiten ausgestattetes Gerät innerhalb der Baureihe eines Herstellers, - weiter verwendet können, so daß überflüssige Investitionen vermieden werden.

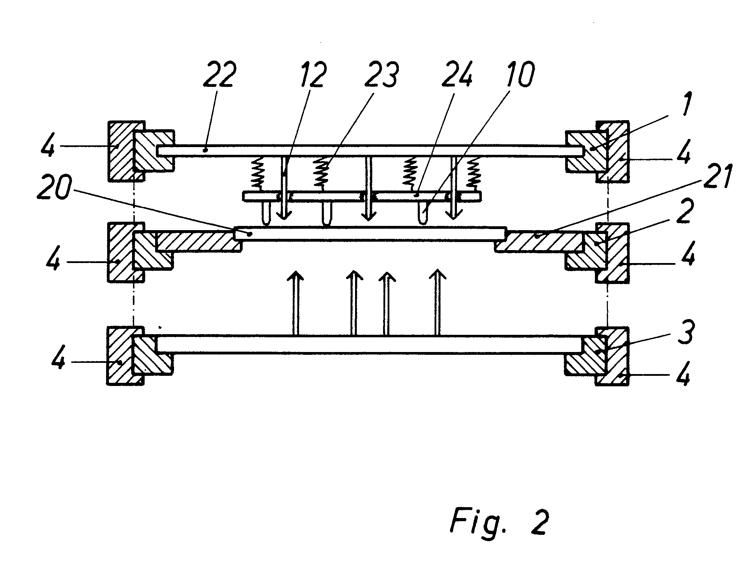

In Fig. 2 sind drei erfindungsgemäße Rahmen 1, 2 und 3 in nutenförmigen Aufnahmeelementen 4 dargestellt, die mit einer Niederhalte- bzw. Kontaktstift-Trägerplatte zur Prüfung einer zweiseitig bestückten Leiterplatte 20 ausgerüstet sind. Die zweiseitig bestückte Leiterplatte 20 liegt in einer Prüflingsaufnahmeplatte 21, was die Prüfung von nicht standardmäßigen Abmessungen aufweisenden Leiterplatten erlaubt. Im oberen Rahmen 1 ist eine Kontaktstift-Trägerplatte 22 mit Kontaktstiften 12 angeordnet, an deren Unterseite über Federn 23 eine zusätzliche Niederhalteplatte 24 mit zapfenförmigen Andrückelementen 10 befestigt ist.

Der untere, in diesem Ausführungsbeispiel eine L-förmige Nut aufweisende Rahmen 3 stützt eine Kontaktstift-Trägerplatte 11 mit Kontaktstiften 12 wie in dem in Figur 1 dargestellten Ausführungsbeispiel.

Durch die erfindungsgemäße Kombination von Rahmen mit in einem bestimmten Abstand angeordneten Aufnahmeelementen wird es erstmalig möglich, auf einen bestimmten Leiterplattentyp zugeschnittene Niederhalte-, Prüflingsaufnahme- und Kontaktstift-Trägerplatten auf einem beliebigen Prüfgerät zu verwenden.

## BEZUGSZEICHENLISTE

1 Rahmen
2 Rahmen
3 Rahmen
4 nutenförmiges Aufnahmeelement
5 Pfeil
6 Pfeil
7 Querriegel
8 Querriegel
9 Niederhalteplatte
10 Andrückelement
11 Kontaktstift-Trägerplatte
12 Kontaktstifte
13 Nut
14 Leiterplatte
15 Bohrung
16 Paßstift
17 hintere Schmalseite (von 2)
18 Bauelemente
19 Typenbezeichnung
20 zweiseitig bestückte zu prüfende Leiterplatte
21 Prüflingsaufnahmeplatte
22 Kontaktstift-Trägerplatte
23 Federn
24 Niederhalteplatte
25
26
27
28
29
30

## Ansprüche

1. Halteeinrichtung für
   a) zu prüfende Leiterplatten, Flachbaugruppen (14), elektromechanische Baugruppen und für
   b) Kontaktstift-Trägerplatten (11) und
   c) Niederhalteplatten (9)

- zur Verwendung in unterschiedlichen Prüfgeräten, mit
- mehreren je eine Platte (9,11) oder Flachbaugruppe (14) aufnehmenden Rahmen (1,2,3)
- und mit in dem jeweiligen Prüfgerät integrierten und/oder mit diesem fest verbundenen Aufnahmeelementen (4) zur Aufnahme der Rahmen (1,2,3),
- die in einem standardisiertem, bei sämtlichen zur Verwendung mit der Halteeinrichtung vorgesehenen Prüfgeräten in gleichen Abstand (a) voneinander angeordnet sind.

2. Halteeinrichtung nach Anspruch 1, dadurch gekennzeichnet, daß die Aufnahmeelemente (4) nutenförmig ausgebildet sind.

3. Halteeinrichtung nach einem der vorhergehenden Ansprüche, dadurch gekennzeichnet, daß die Rahmen (2) auf ihrer Innenseite eine umlaufende, L-förmige Nut (13) zur Aufnahme der Platten (14) aufweisen.

4. Halteeinrichtung nach Anspruch 3, dadurch gekennzeichnet, daß in der L-förmigen Nut (13) mit entsprechenden Ausnehmungen und/oder Bohrungen (15) in der jeweiligen aufzunehmenden Platte (14) korrespondierende Paßstifte (16) angeordnet sind.

5. Halteeinrichtung nach einem der Ansprüche 1 oder 2, dadurch gekennzeichnet, daß die Rahmen (1,3) einen lösbaren Querriegel und eine auf der Innenseite des Rahmens umlaufende U-förmige Nut zur Aufnahme der Platten (9,11) aufweisen.

6. Halteeinrichtung nach einem dar vorhergehenden Ansprüche, gekennzeichnet durch in die Rahmen (2) integrierte Buchsen und/oder Stecker zur Kontaktierung von an den zu prüfenden Leiterplatten bzw. Flachbaugruppen (14) vorhandenen Steckern und/oder Buchsen.

7. Halteeinrichtung nach einem der vorhergehenden Ansprüche, gekennzeichnet durch in die Rahmen (2) integrierte steckerförmige Kontaktelemente zur Aufnahme und Kontaktierung von an den zu prüfenden Leiterplatten oder Flachbaugruppen (14) vorhandenen Messerleisten.

8. Halteeinrichtung nach einem der vorhergehenden Ansprüche, dadurch gekennzeichnet, daß die Rahmen (1,2,3) rechteckförmig sind.

9. Halteeinrichtung nach einem der vorhergehenden Ansprüche, dadurch gekennzeichnet, daß die Innenabmessungen der Rahmen (1,2,3) so ausgelegt sind, daß eine Flachbaugruppe im Europaformat (100 mm x 160 mm) aufgenommen werden kann.

10. Halteeinrichtung nach einem der vorhergehenden Ansprüche, dadurch gekennzeichnet, daß die zu prüfende Leiterplatte bzw. Flachbaugruppe (20) über eine zusätzlche Prüflingsaufnahmeplatte (21) mit dem jeweiligen Rahmen (2) verbunden wird.

11. Halteeinrichtung nach Anspruch 10, dadurch gekennzeichnet, daß die Prüflingsaufnahmeplatte (21) zur Aufnahme mehrerer Leiterplatten ausgelegt ist.

12. Halteeinrichtung nach Anspruch 11, dadurch gekennzeichnet, daß die Prüflingsaufnahmeplatte (21) zur Aufnahme mehrerer Leiterplatten im Europaformat (EP) oder im doppelten Europaformat (DEP) ausgelegt ist.

13. Halteeinrichtung nach Anspruch 11, dadurch gekennzeichnet, daß zumindest einige Rahmen (1,2,3) zur Aufnahme einer Prüflingsaufnahmeplatte (21) der Abmessung 360 x 460 mm ausgelegt sind.

14. Halteeinrichtung nach Anspruch 11, dadurch gekennzeichnet, daß zumindest einige Rahmen (1,2,3) zur Aufnahme einer Prüflingsaufnahmeplatte (21) der Abmessung 220 mm x 240 mm ausgelegt sind.

15. Halteeinrichtung nach einem der Ansprüche 1 bis 11, dadurch gekennzeichnet, daß Breite und Länge der Rahmen (1,2,3) wie 1 : 2 verhalten.

16. Halteeinrichtung nach einem der vorhergehenden Ansprüche, dadurch gekennzeichnet, daß ein größerer und ein kleinerer Rahmentyp vorgesehen sind, wobei die innere Breite des grösseren Typs der äußeren Länge des kleineren und die innere Länge des größeren Typs der doppelten äußeren Breite des kleineren entspricht.

17. Halteeinrichtung nach Anspruch 16, gekennzeichnet durch einen in den größeren Rahmen einlegbaren Steg.

18. Halteeinrichtung nach einem der vorhergehenden Ansprüche, dadurch gekennzeichnet, daß die Rahmen (1,2,3) aus Aluminiumprofilen gefertigt sind.

19. Halteeinrichtung nach einem der vorhergehenden Ansprüche, dadurch gekennzeichnet, daß die Rahmen (1,2,3) aus Stahlprofilen gefertigt sind.

Fig. 1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,P | US-A-4 797 610 (FOMBELLIDA) * Zusammenfassung; Figuren 2,3,5; Spalte 4, Zeilen 26-54; Spalte 5, Zeilen 28-47 * --- | 1,2,8, 10 | G 01 R 31/28 |
| X | EP-A-0 261 829 (MARCONI) * Zusammenfassung; Figur 1; Spalte 4, Absatz 4; Spalte 5, Absätze 1-2 * --- | 1,4,8 | |
| X | FR-A-2 224 972 (CIT-ALCATEL) * Seite 4, Absätze 1-3; Figur 1 * ----- | 2,6,7 | |
| | | | **RECHERCHIERTE SACHGEBIETE (Int. Cl.5)** G 01 R |

Der vorliegende Recherchenbericht wurde für alle Patentansprüche erstellt

| Recherchenort | Abschlußdatum der Recherche | Prüfer |
|---|---|---|
| DEN HAAG | 07-02-1990 | PEDERSEN H.B.B. |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
   Dokument

EPO FORM 1503 03.82 (P0403)